**Europäisches Patentamt**

**European Patent Office**

**Office européen des brevets**

(19)

(11) Veröffentlichungsnummer: **0 021 385**
**B1**

(12) # EUROPÄISCHE PATENTSCHRIFT

(45) Veröffentlichungstag der Patentschrift:
25.05.83

(51) Int. Cl.³: **C 30 B 11/00,** C 30 B 11/10,
C 30 B 29/06, C 01 B 33/02

(21) Anmeldenummer: 80103506.4

(22) Anmeldetag: 23.06.80

(54) **Verfahren zur Herstellung von Siliciumstäben.**

(30) Priorität: 26.06.79 DE 2925679

(43) Veröffentlichungstag der Anmeldung:
07.01.81 Patentblatt 81/1

(45) Bekanntmachung des Hinweises auf die Patenterteilung:
25.05.83 Patentblatt 83/21

(84) Benannte Vertragsstaaten:
**BE DE FR GB IT NL**

(56) Entgegenhaltungen:
**EP-A-0 010 307**
**DE-A-2 745 247**

(73) Patentinhaber: **HELIOTRONIC Forschungs- und
Entwicklungsgesellschaft für Solarzellen-Grundstoffe
mbH, Johannes-Hess-Strasse 24, D-8263 Burghausen
(DE)**

(72) Erfinder: **Helmreich, Dieter, Dr.,
Robert-Koch-Strasse 185, D-8263 Burghausen (DE)**
Erfinder: **Sirtl, Erhard, Prof. Dr., Kiefernweg 11,
D-8261 Marktl/Inn (DE)**
Erfinder: **Zöllner, Theo, Herzogstrasse 30,
D-8261 Mehring-Öd (DE)**

## Verfahren zur Herstellung von Siliciumstäben

Die Erfindung betrifft ein Verfahren zur Herstellung von Siliciumstäben mit Kolumnarstruktur aus einkristallinen Kristallbezirken mit kristallographischer Vorzugsorientierung.

Aufgrund der zunehmenden Verknappung und Verteuerung fossiler Energieträger gewinnen Solarzellen aus Silicium, welche die direkte Umwandlung von Sonnenenergie in elektrische Energie gestatten, steigende Bedeutung. Während diese Art der Energieerzeugung mit Solarzellen aus einkristallinem Silicium im Bereich der Satellitentechnik heute schon die beherrschende Form ist, sind derartige Siliciumsolarzellen für eine terrestrische Anwendung viel zu teuer. Aus der DE-B-2 508 803 sind neuartige, polykristalline Siliciumformkörper und ein Verfahren zu ihrer Herstellung bekanntgeworden, welche nach entsprechender Dotierung als Grundmaterial für Solarzellen eingesetzt werden können und als solche einen Wirkungsgrad um 10% aufweisen. Um mit derartigen Solarzellen neben herkömmlichen Energieträgern bestehen zu können, bedarf es einer kräftigen Verbilligung, welche sich nur durch Produktionsverfahren mit hohem Ausstoß in der Zeiteinheit realisieren läßt. Es ist zwar bekannt, große Siliciumstäbe, beispielsweise durch Gießen, herzustellen, derartige Siliciumstäbe weisen aber nach dem Erstarren keine kristallographische Vorzugsorientierung auf, wie sie für die Verwendung als Grundmaterial für Solarzellen mit hohem Wirkungsgrad erforderlich ist. Gemäß der GB-A-954 849 wird beispielsweise Silicium in ein unten verschlossenes und in ein Wärmeisoliermaterial eingebettetes Quarzrohr eingegossen. Das Silicium verfestigt sich zwar zwangsläufig von unten her, weil von oben her ständig schmelzflüssiges Silicium nachgegossen wird, das Wachstum beginnt jedoch an den Seitenwänden des Quarzrohres, da eine Wärmeabführung nur über die Quarzwand möglich ist. Ein derartiges Verfahren wäre aber, selbst wenn es zu Silicium mit erforderlicher Kristallstruktur führen würde, zur Herstellung von Solarzellen-Grundmaterial nicht geeignet, da es viel zu teuer ist; durch die Wärmeisolierung der Quarzform wird die Erstarrungsgeschwindigkeit und somit die Kristallisationsgeschwindigkeit des Siliciums stark verzögert, außerdem entstehen zusätzliche Kosten für die erforderlichen Quarzformen. Derartige Quarzformen können bei größeren Stäben aufgrund des unterschiedlichen Ausdehnungskoeffizienten von Quarz und festem Silicium, welches bekanntlich beim Erstarren eine Volumenvergrößerung von ca. 10% erfährt, nur einmal verwendet werden. In der GB-A-954 849 wird zwar ausgeführt, daß durch Beschichten der Quarzinnenseite mit Kohlenstoff ein Benetzen zwischen Quarz und Silicium verhindert werden kann, so daß die Quarzform nach dem Erstarren des Siliciums unversehrt abgezogen werden kann, dies gelingt mit Sicherheit jedoch nur bei ganz langsamer Erstarrung, sowie bei geringen Stabdurchmessern in der Größenordnung von etwa 2 cm, entsprechend dem Beispiel in der genannten britischen Patentschrift. Schließlich ist in der DE-A-27 45 247 ein semikontinuierliches Verfahren bekanntgeworden, nach dem sich Siliciumformkörper mit einer Kolumnarstruktur durch Eingießen einer Siliciumschmelze in geeignete Formen und von unten nach oben gerichtetes Erstarrenlassen unter Einfluß eines bestimmten Temperaturgradienten herstellen lassen.

Der Erfindung lag daher die Aufgabe zugrunde, polykristallines Silicium mit für die Herstellung von Solarzellen geeigneter Kristallstruktur in hohem Durchsatz in Form von großen Stäben herzustellen.

Gelöst wird diese Aufgabe durch ein Verfahren, welches dadurch gekennzeichnet ist, daß aus einem Siliciumreservoir beständig oder taktweise Silicium in eine Kristallisationskammer überführt wird, in welcher es auf eine vertikal bewegliche, gekühlte Unterlage, welche in ihren horizontalen Abmessungen mindestens der Querschnittsfläche des herzustellenden Stabes entspricht, in einer solchen Menge ausgebracht wird, daß während des Kristallzüchtens unter der Einwirkung eines parallel zur Stabachse gerichteten Temperaturgradienten ein über dem erstarrenden Silicium stehender Schmelzsee aufrechterhalten wird, dessen Gewichtsmenge dem 0,1- bis 5fachen des pro Minute nach unten auskristalliserenden Siliciums entspricht, welches unter Kühlung über den aus der Kristallisationskammer austretenden Stabteil kontinuierlich nach unten aus der Schmelze abgezogen wird.

Zur Aufnahme des Siliciumreservoirs eignen sich beispielsweise Tiegel, deren bei Flüssignachchargierung mit der Siliciumschmelze in Berührung stehende Oberfläche aus reaktionsgebundenem oder heißgepreßtem Siliciumnitrit, aus Quarz, aus Glaskohle oder aus porendichtem Graphit, wie er beispielsweise durch Imprägnieren einer Graphitoberfläche mit einer, sich bei einer nachfolgenden Temperaturbehandlung zu feinteiligem, die Poren verschließendem, Kohlenstoff zersetzenden organischen Verbindung anfällt. Außerdem lassen sich auch Graphittiegel, deren Innenseite mit reaktionsgebundenem Siliciumcarbid und/oder Siliciumnitrid, gemäß dem in der DE-A-2 739 258 beschriebenen Verfahren beschichtet sind, als Schmelztiegel für die Vorratsschmelze einsetzen.

Besonders vorteilhaft allerdings ist bei Flüssignachchargierung die Beschichtung der mit Siliciumschmelze in Kontakt stehenden Oberfläche der Nachchargiergefäße mit einer Schutzschmelze, da sich in diesen Fällen billiger, grobporiger Graphit einsetzen läßt und die Wiederverwendung dieser Gefäße nicht in Frage gestellt wird.

Als Schutzschmelzen eignen sich solche, deren Schmelzpunkt unterhalb dem des Siliciums liegt, also von 800 bis 1400° C, vorzugsweise 1100 bis 1200° C. Allgemein werden für derartige Schutzschmelzen Verbindungen bevorzugt, deren Dampfdruck im Temperaturbereich von 1400 bis 1500° C möglichst niedrig ist. Auch sollten derartige Schmelzen keine Elemente oder Verunreinigungen enthalten bzw. an Silicium abgeben, die als Lebensdauerkiller für die Minoritätenträger in Silicium angesehen werden können. Auch die Löslichkeit der die Schutzschmelze aufbauenden Komponenten und ihre Verunreinigungen in der Siliciumschmelze sollte möglichst gering sein, d. h. die Schutzschmelze sollte mit Silicium nicht mischbar sein, es sollte sich also zwischen beiden Systemen eine Phasengrenze ausbilden.

Besonders geeignet sind als Schutzschmelzen, Schmelzen aus Erdalkalifluoriden im Gemisch mit 30 bis 90 Mol-% Erdalkalisilikaten, wobei die Zusammensetzung innerhalb der angegebenen Grenzen so beschaffen sein muß, daß der Schmelzpunkt des Gemisches unter dem des Siliciums liegt. Eingesetzt werden können somit die Fluoride und Silikate der Erdalkalielemente Magnesium, Kalzium, Strontium und Barium, wobei allein schon wegen der geringen Kosten Kalzium- und Magnesiumverbindungen bevorzugt werden. Geeignet sind beispielsweise Mischungen aus Magnesiumfluorid mit Kalziumsilikat oder Magnesiumfluorid mit Magnesiumsilikat, Mischungen aus Kalziumfluorid mit Magnesiumsilikat sowie vorzugsweise Mischungen aus Kalziumfluorid und Kalziumsilikat, dies insbesondere aufgrund des gegenüber Magnesiumfluorid erheblich niedrigeren Dampfdruckes des Kalziumfluorids. Besonders geeignete Schutzschmelzen, deren Schmelzpunkt in dem bevorzugten Bereich von 1100 bis 1200° C liegt, sind beispielsweise Mischungen aus Kalziumfluorid mit 40 bis 60 Mol-% Kalziumsilikat.

Gemäß dem erfindungsgemäßen Verfahren lassen sich beispielsweise auch zwei oder mehrere derartiger Tiegel als Siliciumreservoir parallelschalten, so daß nach der Entleerung des einen Tiegels sofort auf einen zweiten mit gleich dotiertem Silicium umgeschaltet werden kann. Die Einbringung der Siliciumschmelze, des Siliciumgranulats oder -pulvers in die Kristallisationskammer kann beispielsweise über ein Zulaufrohr oder eine Zulaufrinne erfolgen, wobei zweckmäßig für kurze Strecken Sorge getragen wird, um eine weitgehende Temperaturkonstanz im Falle zulaufenden, schmelzflüssigen Siliciums zu gewährleisten.

Zur Erzielung eines gleichmäßigen Zulaufs aus dem Siliciumreservoir in die Kristallisationskammer läßt sich bei Flüssigchargierung der Schmelztiegel für die Vorratsschmelze mit einem in axialer Richtung bewegbaren und vorzugsweise dreh-und heizbaren Verdrängungskörper versehen, welcher dem Tiegeldurchmesser in seinen Abmessungen so angepaßt wird, daß er beim Eintauchen bis auf den Grund des Schmelztiegels die Schmelze sukzessive möglichst quantitativ verdrängt. Bei diesem System läßt sich der gleichmäßige Zulauf der Schmelze in die Kristallisationskammer beispielsweise mit Hilfe eines zweiten kleinen Verdrängungskörpers im Boden des ersten Verdrängungskörpers oder im Überlauf selbst vornehmen.

Als Material für den oder die Verdrängungskörper kommen prinzipiell die gleichen Stoffe in Frage, wie sie bereits für die Schmelztiegel angegeben sind, wobei in einer gegebenen Vorrichtung der eingesetzte Schmelztiegel und der in die darin befindliche Siliciumschmelze eintauchende Verdrängungskörper nicht zwingend aus dem gleichen Material sein müssen.

Die Größe des Tiegels für das Siliciumreservoir richtet sich danach, ob er beispielsweise nur als Zwischenbehältnis für die Aufnahme von festem oder flüssigem Silicium aus einem parallel laufenden kontinuierlichen Reinigungsprozeß dient, oder ob das Verfahren kontinuierlich oder nur semikontinuierlich betrieben wird. In letzterem Fall würde der Tiegel in seinen Dimensionen zweckmäßig so gewählt, daß die darin aufnehmbare Siliciummenge für den herzustellenden Stab ausreichend ist, während der Zeit, in welcher der Siliciumstab ausgebaut wird, kann dann der Tiegel wieder leicht mit der für die Herstellung eines zweiten Siliciumstabes erforderlichen Siliciummenge befüllt oder gegen einen zweiten bereits frisch befüllten Tiegel ausgetauscht werden.

Gemäß der bevorzugten Ausführungsform erfolgt die Nachchargierung von Silicium über einen oberhalb der Kristallisationskammer angeordneten, mit einer im Boden ausgebildeten, vermittels einer drehbaren, vertikal beweglichen Stopfenstange verschließbaren Öffnung versehenen Tiegel. Die im Boden dieses Tiegels befindliche Öffnung wird zweckmäßig in der Form einer sich im Querschnitt kontinuierlich verjüngenden, kreisrunden Bohrung ausgebildet, welche mit einer unten entsprechend konusförmig ausgebildeten Stopfenstange verschlossen oder geöffnet bzw. unter Einstellung eines definierten Ringspaltes verkleinert werden kann. Im Falle der Flüssignachchargierung wird der innere Teil des Tiegels mit der Auslauföffnung und der Stopfenstange mit einer der vorstehend bereits beschriebenen Schutzschmelzen imprägniert, um seine Wiederverwendbarkeit sicherzustellen.

Die eigentliche Kristallisationskammer besteht nach der bevorzugten Ausführungsform im wesentlichen aus einem Ziehrohr, dessen Hohlquerschnitt dabei abhängig von der beabsichtigten Form, d. h. von der angestrebten Querschnittsfläche des herzustellenden Siliciumstabes ist. Der Hohlquerschnitt kann demnach nicht nur rund, sondern auch eckig, beispielsweise rechteckig oder quadratisch sein. Wird beispielsweise die quadratische Querschnittsform mit insbesondere Kantenlängen von 10 cm gewählt, so fallen Siliciumstäbe an, die durch einfaches Zersägen senkrecht zur Längsachse in Scheiben für die Herstellung von Solarzellen Zerteilt werden können, die die technisch günstige Größe von ca. 100 cm² aufweisen. Die eckige Ausführungsform hat dabei prinzipiell gegenüber der runden den Vorteil der größeren Belegungsdichte der hierbei erhaltenen Siliciumscheiben bei der Herstellung von Solargeneratoren.

Die Kristallisationskammer wird unten mit einer auf einer vertikal bewegbaren Welle aufsitzenden, kühlbaren Unterlage, beispielsweise aus Graphit, abgeschlossen, die in den horizontalen Abmessungen zeckmäßig auf die Form der Kristallisationskammer abgestellt wird und mindestens der angestrebten Querschnittsfläche des herzustellenden Siliciumstabes entspricht.

Bei der Auswahl eines geeigneten Materials zur Fertigung der Kristallisationskammer ist darauf zu achten, daß das Ziehrohr von Schutzschmelzen der eingangs geschilderten Art benetzt wird. Geeignete Materialien sind beispielsweise Siliciumcarbid, Siliciumnitrid, Graphit oder imporbeschichteter Graphit. Für die Auswahl geeigneter Schutzschmelzen für die Kristallisationskammer gilt dabei ganz allgemein, daß von ihnen die Kristallisationskammer stärker benetzt werden muß als durch Silicium, woraus eine relativ hohe Oberflächenspannung dieser Schutzschmelzenschicht resultiert und damit eine geeignete Grenzflächenspannung zwischen dieser Schicht und dem angrenzenden Silicium. Andererseits soll die Viskosität der Schutzschmelze aber auch nicht zu hoch sein, so daß sich ein dünner Schmelzfilm in der Größenordnung von etwa 10 bis 20 μm ausbilden kann. Diese Kriterien werden von den einleitend bereits beschriebenen Schutzschmelzen erfüllt, wobei sich insbesondere die Kalziumsilikat/-fluoridschlacken bestens bewährt haben.

Zur Erzielung einer gerichteten Erstarrung des Siliciums mit der Ausbildung einer Kolumnarstruktur aus einkristallinen Kristallbezirken mit kristallographischer Vorzugsorientierung wird senkrecht zur Wachstumsfront ein nach oben gerichteter Temperaturgradient eingestellt. Durch Beheizung der Kristallisationskammer für die Herstellung von Stäben mit vergleichsweise kleinem Querschnitt kann beispielsweise eine Widerstandsheizung eingesetzt werden, während sich insbesondere für Stäbe mit großen Durchmessern von 5 cm oder mehr eine Mittelfrequenzheizung mit großem Streufeld besonders gut eignet. Prinzipiell kann die Heizung direkt oder auch indirekt, beispielsweise über die abgestrahlte Wärme induktiv beheizter Graphitplatten erfolgen. Die Kristallisationskammer wird zweckmäßig in ihrem oberen Teil auf Temperaturen um 1440° C, also über den Schmelzpunkt des Siliciums, entsprechend etwa der Temperatur der eingegossenen Siliciumschmelze aufgeheizt, während das untere Ende der Kristallisationskammer etwa bei einer Temperatur von 1300 bis 1380° C gehalten wird.

Während des Wachstums des Halbleiterstabes wird die gekühlte Unterlage und der darauf auskristallisierende Halbleiterstab kontinuierlich nach unten abgezogen. Vorzugsweise wird bei Beginn der Kristallzüchtung auf die gekühlte Unterlage ein plattenförmiger Keimkristall gelegt, welcher in seinen horizontalen Abmessungen im wesentlichen der angestrebten Querschnittsfläche des herzustellenden Siliciumstabes entspricht. Zur Konstanthaltung des Wachstumgefüges und zur Gewährleistung einer senkrecht zur Kristallisationsfront ausgebildeten Kolumnarstruktur aus einkristallinen Kristallbezirken mit Vorzugsorientierung wird vorzugsweise als plattenförmiger Impfkristall eine Keimplatte mit parallel zur Wachstumsrichtung ausgebildeter Kolumnarstruktur, beispielsweise mit parallel zur Wachstumsrichtung ausgebildeten Zwillingsebenen eingesetzt. Vorzugsweise wird der auskristallisierende Siliciumstab aus einer rohrförmigen Kristallisationskammer aus Graphit abgezogen. Nach dem Austritt des Siliciumstabes aus der Kristallisationskammer ist es von Vorteil, diesen vor der weiteren Abkühlung noch eine Nachheizzone von etwa 1150 bis 1300° C durchlaufen zu lassen, welche in der Länge mindestens etwa dem Durchmesser des Siliciumstabes entspricht, wobei diese Zone apparativ auch in die Kristallisationskammer integriert sein kann, wobei unter der eigentlichen Kristallisationskammer dann der Teil verstanden werden soll, der die im vorstehenden Absatz beschriebenen Temperaturen aufweist. Der im weiteren Verlauf des Züchtungsprozesses aus der Kristallisationskammer kontinuierlich nach unten austretende Siliciumstab wird durch geeignete Maßnahmen gekühlt, beispielsweise über einen Satz um den Stab angeordneter Ringdüsen, aus welchen er mit einem inerten Kühlgas, beispielsweise Argon oder Stickstoff, angeblasen wird. Die Kühlung wird dabei so eingeregelt, daß der Siliciumstab nach einem Abstand von etwa 30 bis 40 cm von der Kristallisationsfront eine Temperatur von etwa 700 bis 800° C aufweist, wobei der mittlere Temperaturgradient längs dieser Strecke innerhalb 5 bis 25° C pro cm liegen soll. Ist der Stab einmal auf eine Temperatur von 600 bis 700° C abgekühlt, so ist der plastische Bereich unterschritten und die weitere Abkühlung bleibt unkritisch.

Die Kristallisationsfront liegt auf jeden Fall noch innerhalb der vorzugsweise rohrförmigen Kristallisationskammer, wodurch ein Abtropfen der Schmelzzone — wie beispielsweise beim tiegelfreien Zonenziehen oder verwandten Verfahren — nicht befürchtet werden muß, außerdem läßt sich der Ziehvorgang jederzeit in der schutzschmelzegeschützten Kristallisationskammer durch Einfrieren unterbrechen bzw. durch einfaches Hochregeln der Temperatur wieder in Gang setzen.

Die Lage der Kristallisationsfront läßt sich in einfacher Art und Weise, beispielsweise durch Ultraschallmessung oder durch einen in der Wandung der Kristallisationskammer eingeführten Satz von Temperaturfühlern anhand entsprechender Eichkurven ermitteln. Ein Rechner kann anschließend die ermittelten Werte mit vorgegebenen Sollwerten vergleichen und entsprechend die für das Kristallwachstum maßgeblichen Regelgrößen steuern. Derartige Regelgrößen sind neben der Ziehgeschwindigkeit beispielsweise der eingestellte Temperaturgradient, d. h. die Kühlung des aus der Kristallisationskammer ausfahrenden Siliciumstabes, bzw. die Beheizung und somit Temperaturverteilung längs der Kristallisationskammer selbst, sowie die Temperatur des nachchargierten Siliciums und des Schmelzsees über der Kristallisationsfront.

Das im Verfahren eingesetzte Silicium kann prinzipiell flüssig oder fest zugeführt werden. Beispielsweise kann das nach dem Verfahren gemäß der DE-A-2 722 783 anfallende Siliciumgranulat direkt in den Schmelzsee über der Kristallisationsfront eingebracht werden, ohne daß es vorher aufgeschmolzen werden muß. Bei diesem Reinigungsverfahren wird dem Auslaugen metallurgisch reinen Siliciums mit einem Siliciumgehalt von über 95 Gew.-% mit einer Silicium im wesentlichen nicht angreifenden Säurelösung eine mechanische, zu einer kontinuierlichen Kornverkleinerung führende Beanspruchung überlagert. Das nach diesem Reinigungsprozeß anfallende Silicium kann entweder direkt — wie beschrieben — eingesetzt werden oder, wenn die Anforderungen an die Reinheit des herzustellenden Siliciumstabes höher sind, auch einer weiteren Nachreinigung, wie beispielsweise in der DE-A-2 722 784 beschrieben, unterzogen werden. Gemäß diesem Verfahren taucht eine sich drehende, unter den Schmelzpunkt des zu reinigenden Siliciums gekühlte, aus gegenüber Silicium inertem Material bestehende Walze, in das aufgeschmolzene Silicium ein, so daß auf der Oberfläche der Walze Silicium erstarrend anwächst und beim Austritt aus der Schmelze nach Durchlauf einer nachgeschalteten Zone hoher, über dem Schmelzpunkt von Silicium liegender Temperatur dieses erstarrt anhaftende Silicium erneut aufschmilzt und solcherart der Kristallisationskammer gemäß dem erfindungsgemäßen Verfahren zugeführt werden kann. Das erfindungsgemäße Verfahren läßt sich aber auch mit jedem anderen handelsüblichen, reinen Silicium durchführen, bzw. mit anderen bekannten Reinigungsverfahren kombinieren.

Ist das im Verfahren eingesetzte, stückige oder bereits flüssige Silicium noch nicht dotiert oder weicht der Dotierstoffgehalt von der für den herzustellenden, polykristallinen Siliciumstab gewünschten Dotierung ab, so wird ihm vor dem Einbringen in die Kristallisationskammer noch die berechnete Menge an Dotierstoff zugeschlagen. Als Dotierstoffe kommen dabei Aluminium, Bor, Gallium oder Indium bzw. Phosphor, Arsen oder Antimon in Frage, wobei bei der Herstellung von Solarzellen-Grundmaterial üblicherweise eine Bor- oder Phosphordotierung bevorzugt wird.

Auch die Schutzschmelze für die Kristallisationskammer und ggf. die Nachchargierkammer mit Stopfenstange wird ebenfalls zweckmäßig dem kontinuierlich zugeführten Silicium beigegeben, da es mit dem auskristallisierenden Siliciumstab teilweise dem System entzogen wird.

Der auskristallisierende Siliciumstab kann ohne Unterbrechung des Verfahrens nach einer bestimmten Länge jeweils abgeschnitten werden oder das Verfahren wird durch Ausfrieren jeweils kurzzeitig unterbrochen. Eine Bruchgefahr für die Kristallisationskammer ist aufgrund der Imprägnierung mit Schutzschmelze bei der gerichteten Erstarrung nicht gegeben.

Gegenüber bekannten Gießverfahren zur Herstellung von Solarzellen Grundmaterial hat das erfindungsgemäße Verfahren zahlreiche Vorteile: Es kann kontinuierlich durchgeführt werden, durch die schutzschmelzengeschützte Kristallisationskammer werden im Unterschied zur Gießform keine Verunreinigungen eingeschleust, außerdem werden die Kristallisationszeiten erheblich verkürzt, da in der Kristallisationskammer immer nur eine minimale Schmelzmenge über dem bereits erstarrten Silicium aufsteht und die Wärme somit leicht über den Stab abgeführt werden kann.

Die nachfolgenden Ausführungsbeispiele wurden in Vorrichtungen durchgeführt, wie sie in den beiden Abbildungen schematisch dargestellt sind:

Fig. 1 zeigt eine rohrförmige Kristallisationskammer mit einem darüber angeordneten Tiegel mit Stopfenstange zum Nachchargieren schematisch im Längsschnitt.

Fig. 2 zeigt eine Kristallisationskammer mit Nachheizzone.

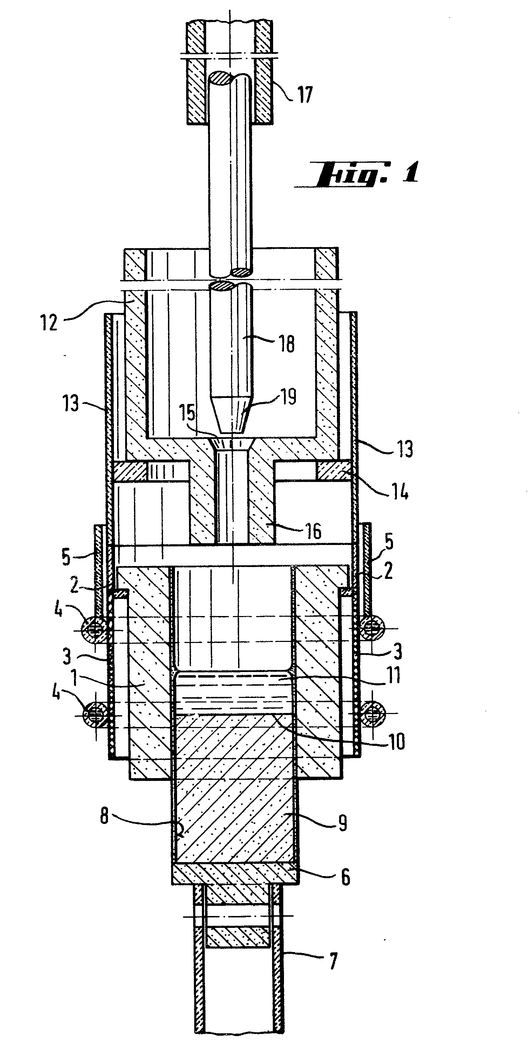

In Fig. 1 ist eine rohrförmige Kristallisationskammer 1 aus beispielsweise Graphit über die Halterung 2 aus beispielsweise elektrisch isolierendem Quarz in die Induktionsheizspule 3 mit der Wasserkühlung 4 eingehängt. Der zusätzliche Quarzring 5 dient lediglich der leichteren Einpassung der oberen Vorrichtungsbestandteile. Der Boden 6 aus Graphit sitzt auf einem vertikal beweglichen Rohr 7 aus beispielsweise Quarz auf, welches von einem Kühlmedium, beispielsweise Luft, durchströmt werden kann.

Der dünne Schutzschmelzenfilm 8 ermöglicht ein problemloses Abziehen des auf der gekühlten Platte 6 kristallin aufwachsenden Siliciumstabes 9 aus der Kristallisationskammer 1, während aus dem Siliciumreservoir der überstehenden Nachchargiereinrichtung 12 aus beispielsweise Graphit nach Maßgabe der Kristallisation festes oder flüssiges Silicium nachgeführt werden kann.

Der Nachchargiertiegel 12, der beispielsweise durch einen, in einem Quarzrohrstück 13 befindlichen Quarzring 14 gehalten wird, weist in der Mitte eine sich konisch nach unten verjüngende Ausflußöffnung 15 auf, die sich in ein nach unten angesetztes Führungsrohr 16 fortsetzt. Diese Ausflußöffnung 15 kann durch eine zweckmäßig ebenfalls aus Graphit gefertigte und über die Antriebswelle 17 drehbare und vertikal verstellbare Stopfenstange 18, die an ihrem unteren Ende 19 paßgerecht ebenfalls konisch nach unten sich verjüngend ausgebildet ist, verschlossen und unter Ausbildung eines Ringspaltes oder gänzlich geöffnet werden.

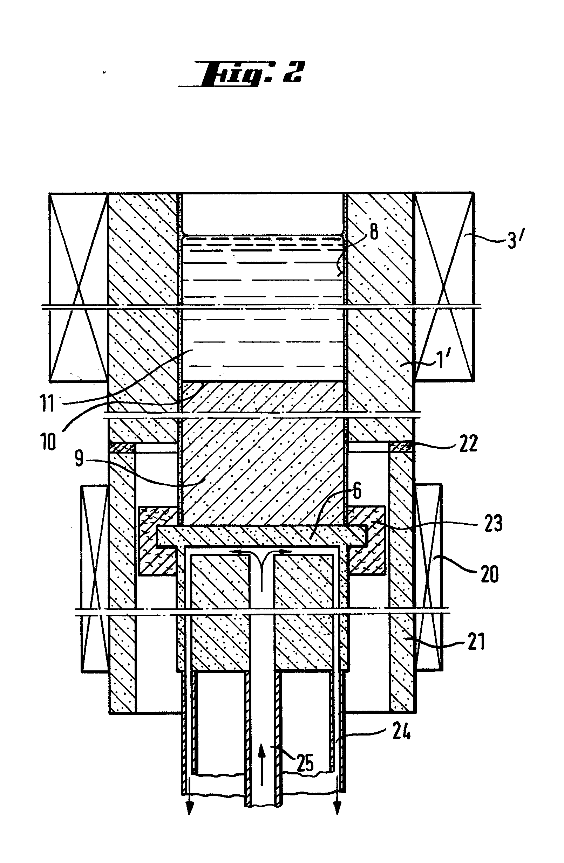

Fig. 2 zeigt wiederum eine von einer Heizeinrichtung 3' umgebene Kristallisationskammer 1' mit über einen Schutzschmelzenfilm 8 abgetrennten Siliciumstab 9 mit oberhalb der Kristallisationsfront 10 überschichtetem Siliciumschmelzsee 11. Der Siliciumstab 9 wird nach unten in eine Nachheizzone gezogen, bestehend aus einem von einer Widerstandsheizung 20 umgebenen Graphitrohr 21, welches durch einen Isolierring 22 von der Kristallisationskammer 1' aus Graphit abgetrennt ist. Der Kühlboden 6 ist gegen die Wärmestrahlung des Graphitrohres 21 durch eine Wärmeisolierung 23 aus beispielsweise Quarz oder Asbest abgeschirmt. Der Boden 6 sitzt auf einem doppelwandigen Quarzrohr 24 auf, in welches ein flüssiges oder gasförmiges Kühlmedium durch ein zentrales Rohr 25 direkt an die Unterseite des Kühlbodens 6 gebracht wird und von dort über die Doppelwandung wieder abfließt.

## Beispiel 1

Es wurde in einer Vorrichtung, wie sie in Fig. 1 dargestellt ist, gearbeitet. Die außen zylindrisch ausgeführte Kristallisationskammer wies einen Durchmesser von 49 mm auf bei einer Höhe von 50 mm und einem quadratischen Innenquerschnitt von $30 \times 30$ mm mit leicht verrundeten Kanten ($r = 2$ mm). Der vertikal bewegliche Boden hatte eine Dicke von 5 mm und bestand, wie die Kristallisationskammer, aus Graphit, außerdem waren die Graphitteile durch Eintauchen in eine Schutzschmelze aus Kalziumsilikat ($CaSiO_3$) und Kalziumfluorid ($CaF_2$) zu gleichen Teilen imprägniert.

Aus einer Nachchargiervorrichtung entsprechend Fig. 1 aus Graphit wurde durch leichtes Anheben und Drehen der Stopfenstange Siliciumgranulat mit einer Korngröße von 0,4 bis 4 mm, vermengt mit etwa 5 Gew.-% $CaSiO_3 \cdot CaF_2$, in die Kristallisationskammer überführt und dort kontinuierlich aufgeschmolzen.

Die Induktionsheizung wurde nach Ausbildung eines Schmelzsees in der Kristallisationskammer so eingeregelt, daß am oberen Rand der Kammer eine Temperatur von etwa 1450° C herrschte, die zum Boden hin bis auf ca. 1350° C abfiel. An der Bodenplatte, die auf einem Quarzrohr aufsaß, begann das Silicium stengelartig auszukristallisieren, worauf die Bodenplatte mit einer Geschwindigkeit von anfangs 10 mm/Minute bis letztlich 25 mm/Minute nach unten abgezogen wurde, wobei der aus der Kristallisationskammer austretende Stabteil durch die umgebende Atmosphäre gekühlt wurde. Die Höhe des Schmelzsees wurde durch Nachchargierung während des Kristallzüchtens auf etwa 10 mm eingestellt. Nach ca. 35 Minuten wurde der Versuch abgebrochen. Es resultierte ein Siliciumstab von 700 mm Länge und einem Querschnitt von $30 \times 30$ mm. Der Stab wies eine Kolumnarstruktur aus einkristallinen Kristallbezirken mit einer Vorzugsorientierung (der 111-Richtung) auf.

## Beispiel 2

In einer rohrförmigen Kristallisationskammer entsprechend Fig. 2 aus mit $CaSiO_3 \cdot CaF_2$ imprägniertem Graphit mit den Dimensionen 180 mm für den Außendurchmesser, 150 mm für die Höhe und $100 \times 100$ mm² für den quadratischen Innenquerschnitt mit leicht verrundeten Ecken ($r = 2$ mm) wurden 900 g vorgereinigtes Siliciumgranulat mit einem Gehalt von 10 ppm Bor und 1 ppm Phosphor aufgeschmolzen. Beim Aufschmelzen des Siliciumgranulates wurde die Heizleistung der Induktionsheizspule so eingeregelt, daß eine Impfkristallplatte aus Silicium mit Kolumnarstruktur auf der Bodenplatte nur angeschmolzen wurde. Der Boden von 10 mm Höhe bestand dabei ebenfalls aus Graphit und war, bis auf eine Aussparung von $100 \times 100$ mm² für die Keimplatte, nach unten wärmeisoliert.

Durch langsames Zurückregeln der Temperatur auf ca. 1350° C am unteren Ende der Kristallisationskammer setzte sich das durch den Impfkristall vorgegebene kolumnare Kristallwachstum in dem anwachsend erstarrenden Silicium fort. Der Siliciumstab wurde mit einer Geschwindigkeit von durchschnittlich etwa 20 mm/Minute abgezogen, wobei der Stab eine sich unmittelbar an die Kristallisationskammer anschließende Nachheizzone von etwa 1350 bis 1200° C durchlief, in welcher er spannungsfrei getempert wurde. Gleichzeitig wurde hierdurch erreicht, daß die Isothermen auch im weiteren Abstand von der Kristallisationsfront flach waren und nahezu senkrecht zur Abziehrichtung standen. Nach Durchlaufen der Nachheizzone, die auf eine Stablänge von ca. 15 cm einwirkte, wurde der Siliciumstab durch Anblasen mit Stickstoff durch einen konzentrisch um den Stab angeordneten Satz von Düsen weiter abgekühlt.

Durch eine Nachchargiervorrichtung, wie sie in Fig. 1 dargestellt ist, aus schutzschmelzeimprägniertem ($CaSiO_3 \cdot CaF_2$) Graphit wurde vorgereinigtes schmelzflüssiges Silicium mit einem Gehalt an 10 ppm Bor und 1 ppm Phosphor neben etwa 5 Gew.-% $CaSiO_3 \cdot CaF_2$ in einer solchen Menge kontinuierlich nachgeführt, daß in der Kristallisationskammer ein Siliciumschmelzsee von etwa 10 mm Höhe aufrechterhalten wurde. Der Nachchargiertiegel hatte dabei ein Fassungsvermögen von etwa 20 Litern Siliciumschmelze nebst 5 Gew.-% Schutzschmelze. Durch die Imprägnierung auch dieses Graphittiegels sowie der Stopfenstange aus Graphit mit Kalziumsilikat-Kalziumfluorid gelang ein wiederholtes Verschließen und Wiederöffnen des Bodenablaufs ohne Zusammenbacken durch reaktionsbedingtes Siliciumcarbid, wie es bei nicht imprägnierten Graphitteilen der Fall wäre.

Nachdem der Siliciumstab mit einer Querschnittsfläche von $100 \times 100$ mm² eine Länge von 1000 mm erreicht hatte, wurde die Nachchargierung unterbrochen, die überstehende Schmelze ausgefroren und der Stab der Ziehapparatur entnommen. Nach dem Hochfahren des mit einer neuen Keimplatte versehenen Bodens der Kristallisationskammer wurde in der gleichen Art ein zweiter Siliciumstab hergestellt. Vor der Herstellung weiterer Stäbe wurde der geleerte Nachchargiertiegel durch einen zweiten, neu befüllten ausgetauscht.

Die Siliciumstäbe wurden anschließend in Scheiben von 400 mm Dicke zersägt und zu Solarzellen weiterverarbeitet.

## Patentansprüche

1. Verfahren zur Herstellung von Siliciumstäben mit Kolumnarstruktur aus einkristallinen Kristallbezirken mit kristallographischer Vorzugsorientierung, dadurch gekennzeichnet, daß aus einem Siliciumreservoir beständig oder taktweise Silicium in eine Kristallisationskammer überführt wird, in welcher es auf eine vertikal bewegliche, gekühlte Unterlage, welche in ihren horizontalen Abmessungen mindestens der Querschnittsfläche des herzustellenden Stabes entspricht, in einer solchen Menge ausgebracht wird, daß während des Kristallzüchtens unter der Einwirkung eines parallel zur Stabachse gerichteten Temperaturgradienten ein über dem erstarrenden Silicium stehender Schmelzsee aufrechterhalten wird, dessen Gewichtsmenge dem 0,1- bis 5fachen des pro Minute nach unten auskristallisierenden Silicium entspricht, welches unter Kühlung über den aus der Kristallisationskammer austretenden Stabteil kontinuierlich nach unten aus der Schmelze abgezogen wird.

2. Verfahren nach Anspruch 1, dadurch gekennzeichnet, daß bei Beginn des Kristallzüchtungsprozesses ein gekühlter, plattenförmiger Keimkristall unterlegt wird, welcher in seinen horizontalen Abmessungen im wesentlichen der angestrebten Querschnittsfläche des herzustellenden Siliciumstabes entspricht.

3. Verfahren nach Anspruch 1 oder 2, dadurch gekennzeichnet, daß der auskristallisierende Siliciumstab aus einer ohrförmigen Kristallisationskammer aus Graphit abgezogen wird.

4. Verfahren nach einem oder mehreren der Ansprüche 1 bis 3, dadurch gekennzeichnet, daß der direkte Kontakt zwischen Silicium und der Innenwandung der rohrförmigen Kristallisationskammer durch Dazwischenbringen einer Schutzschmelze verhindert wird.

5. Verfahren nach Anspruch 4, dadurch gekennzeichnet, daß als Schutzschmelze eine Schmelze aus Erdalkalifluoriden im Gemisch mit 30 bis 90 Mol-% Erdalkalisilikaten und einem Schmelzpunkt unterhalb dem des Siliciums eingesetzt wird.

6. Verfahren nach Anspruch 4 und 5, dadurch gekennzeichnet, daß als Schutzschmelze eine Schmelze aus Kalziumfluorid im Gemisch mit 40 bis 60 Mol-% Kalziumsilikat eingesetzt wird.

7. Verfahren nach einem oder mehreren der Ansprüche 1 bis 6, dadurch gekennzeichnet, daß die Nachchargierung über einen oberhalb der Kristallisationskammer angeordneten, mit einer im Boden ausgebildeten, vermittels einer drehbaren, vertikal beweglichen Stopfenstange verschließbaren Öffnung versehenen Tiegel erfolgt.

## Claims

1. Method for the production of silicon rods having a columnar structure of monocrystalline crystal zones with a preferential crystallographic orientation, characterised in that silicon is transferred continuously or semi-continuously from a silicon reservoir into a crylstallisation chamber, in which it is discharged in such a quantity onto a vertically mvable, cooled support, which, in its horizontal dimensions, corresponds at least to the cross-sectional face of the rod to be produced, that a molten deposit is maintained above the solidifying silicon during the crystal growth under the influence of a temperature gradient directed parallel to the rod axis, the amount by weight of the molten deposit corresponding to 0.1 to 5 times that of the silicon which crystallises in a downward direction per minute, wherein the silicon is continuously pulled with cooling, in a downward direction out of the melt using the rod portion emerging from the crystallisation chamber.

2. Method according to claim 1, characterised in that, at the start of the crystal growing process, a cooled plate-shaped seed crystal is placed underneath the rod to be produced which, in its horizontal dimensions, corresponds substantially to the desired cross-sectional face of the silicon rod to be produced.

3. Method according to claim 1 or 2, characterised in that the crystallising silicon rod is pulled from a tubular crystallisation chamber made of graphite.

4. Method according to one or more of claims 1 to 3, characterised in that the direct contact between the silicon and the inner wall of the tubular crystallisation chamber is avoided by interposing a protective melt.

5. Method according to claim 4, characterised in that a melt of alkaline earth metal fluorides in admixture with 30 to 90 mole% of alkaline earth metal silicates and having a melting point below that of the silicon is used as the protective melt.

6. Method according to claim 4 and 5, characterised in that a melt of calcium fluoride in admixture with 40 to 60 mole % of calcium silicate is used as the protective melt.

7. Method according to one or more of claims 1 to 6, characterised in that the recharging of silicon is carried out using a crucible arranged above the crystallisation chamber and having in its base an opening which may be closed by means of a rotatable, vertically movable stopper rod.

## Revendications

1. Procédé de production de barreaux en silicium à structure columnaire à partir d'un domaine monocristallin à orientation cristallographique privilégiée, procédé caractérisé en ce qu'à partir d'un réservoir de silicium du silicium est, continuellement ou périodiquement, transféré dans une chambre de cristallisation dans laquelle il est introduit sur un support refroidi, mobile verticalement, dont les dimensions horizontales correspondent au moins à la surface de section droite du barreau à produire, en une quantité telle que pendant la croissance cristalline sous l'effet d'un gradient de température dirigé parallèlement à l'axe du barreau, on maintienne toujours au-dessus du silicium en cours de solidification une zone fondue dont la quantité pondérale représente 0,1 à 5 fois la quantité de silicium cristallisant par minute vers le bas et que l'on retire continuellement de la masse fondue, vers le bas, en le refroidissant à l'aide d'une partie de barreau sortant de la chambre de cristallisation.

2. Procédé selon la revendication 1, caractérisé en ce qu'au début du processus de croissance cristalline on place un germe cristallin refroidi, en forme de plaque dont les mesures horizontales correspondent essentiellement à la surface de section droite voulue pour le barreau de silicium à produire.

3. Procédé selon la revendication 1 ou 2, caractérisé en ce que le barreau de silicium est retiré d'une chambre de cristallisation, en forme de Tube en graphite.

4. Procédé selon l'une quelconque des revendications 1 à 3, caractérisé en ce qu'on évite le contact direct entre le silicium et la paroi interne de la chambre de cristallisation en forme de tube, par interposition d'une masse de matière protectrice fondue.

5. Procédé selon la revendication 4, caractérisé en ce qu'on utilise comme matière protectrice fondue une masse fondue de fluorures alcalino-terreux mélangés avec 30 à 90 moles % de silicates alcalino-terreux et dont le point de fusion est inférieur à celui du silicium.

6. Procédé selon la revendication 4 ou 5, caractérisé en ce qu'on utilise comme matière protectrice fondue une masse fondue de fluorure de calcium en mélange avec 40 à 60 moles % de silicate de calcium.

7. Procédé selon l'une quelconque des revendications 1à 6, caractérisé en ce que le post-chargement est réalisé à l'aide d'un creuset disposé au-dessus de la chambre de cristallisation, comportant un orifice ménagé dans son fond et qui peut être obturé à l'aide d'une barre rotative de bouchage mobile verticalement.

0 021 385

**Fig. 1**

9

# Fig. 2